# EUROPÄISCHE PATENTSCHRIFT

(11) **EP 2 718 396 B1**
(45) Veröffentlichungstag und Bekanntmachung des Hinweises auf die Patenterteilung: **14.02.2018**
(21) Anmeldenummer: 12766927.3
(22) Anmeldetag: 05.09.2012
(51) Int. Cl.: C09K 11/08, C09K 11/77, H01L 33/50

(54) **Beleuchtungseinheit**
Illumination unit
Unité d'éclairage

(30) Priorität: 23.09.2011 DE 202011106052 U
(43) Veröffentlichungstag der Anmeldung: 16.04.2014
(73) Patentinhaber: OSRAM GmbH, 80807 München (DE); OSRAM Opto Semiconductors GmbH, 93055 Regensburg (DE)
(72) Erfinder: HUCKENBECK, Barbara, 86159 Augsburg (DE); CUI, Hailing, 93051 Regensburg (DE); JERMANN, Frank, 86343 Königsbrunn (DE)
(74) Vertreter: Epping - Hermann - Fischer
(86) Internationale Anmeldenummer: PCT/EP2012/067337
(87) Internationale Veröffentlichungsnummer: WO 2013/041377

(56) Entgegenhaltungen:
- WO-A1-2011/160944
- DE-A1-102006 016 548
- JP-A- 2007 137 946
- JP-A- 2009 040 944
- US-A1- 2006 232 193

## Beschreibung

### Technisches Gebiet

Die Erfindung geht aus von einer Lichtquelle gemäß dem Oberbegriff des Anspruchs 1, insbesondere einer Konversions-LED. Derartige Konversions-LEDs sind insbesondere für Allgemeinbeleuchtung geeignet.

### Stand der Technik

Aus der US-B 7 489 073 ist eine Konversions-LED bekannt, die als Leuchtstoff ein modifiziertes reguläres Orthosilikat verwendet.
Die Druckschrift WO 2011/160944 A1 betrifft einen Leuchtstoff auf der Basis von modifiziertem M₂SiO₄:D und eine Lichtquelle mit einem solchen Leuchtstoff.
In der Druckschrift DE 10 2006 016 548 A1 und in der Druckschrift US 2006/0232193 A1 ist je ein blau bis orange emittierender Leuchtstoff und eine zugehörige Lichtquelle beschrieben.
Stabile grüne Leuchtstoffe, insbesondere mit einem Emissionsmaximum um 520-540 nm, stehen kaum zur Verfügung.
Das erschwert den Einsatz von Konversions-LEDs bei der Displayhinterleuchtung und schränkt die Optimierung von High-CRI-LEDs oder Warmweiß-LEDs ein. Bisher werden in Produkten hauptsächlich Orthosilikate als Grünleuchtstoffe für diesen Bereich eingesetzt. Diese besitzen zwar teils hohe Quanteneffizienzen, zeigen aber ein unzureichendes Alterungsverhalten in LEDs.

Aus der US-B 7,489,073 ist ein Nitrido-Orthosilikat mit der Zusammensetzung AE₂₋ₓ₋ₐREₓEuₐSiO₄₋ₓNₓ (AE=Sr, Ba, Ca, Mg; RE=Seltene Erden, insbesondere Y und/oder La) bekannt. EA oder auch AE steht hier für Erdalkali-Elemente. Durch den Einbau von YN und/oder LaN wird eine Rotverschiebung der spektralen Lage und zumeist eine Verbesserung der Quanteneffizienz des Leuchtstoffes erreicht. Das LED-Alterungsverhalten dieses Leuchtstoffs ist bereits mit dem dort beschriebenen Herstellverfahren deutlich besser als bei den konventionellen Orthosilikaten oder anderen grünen Sion-Leuchtstoffen wie z. B. Ba₃Si₆O₁₂N₂:Eu.

Für viele Anwendungen, wie z. B. für LCD-Hintergrundbeleuchtung, ist die Stabilität in feuchter Umgebung und bei höheren Temperaturen jedoch immer noch nicht optimal.

### Darstellung der Erfindung

Die Aufgabe der vorliegenden Erfindung ist es, eine Beleuchtungseinheit gemäß dem Oberbegriff des Anspruchs 1 bereitzustellen, die es gestattet, hohe Effizienz und Stabilität zu erzielen.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt ein neuartiger nitridischer Leuchtstoff bereitgestellt. Darunter fallen blau bzw. blaugrün bis gelb emittierende Leuchtstoffe, die insbesondere im Emissionsbereich typischer UV- und Blau-LEDs anregbar sind und gleichzeitig eine sehr hohe Stabilität in der LED aufweisen. Anwendungen können die Leuchtstoffe insbesondere in LEDs mit guter Farbwiedergabe, in LEDs für LCD-Hintergrundbeleuchtung, Color-on-demand LEDs oder weißen OLEDs finden. Auch ein Einsatz bei Laser Remote-Phosphor-Geräten (LARP) oder LED Remote Phosphor-Geräten ist möglich.

Weiße Halbleiter-basierte Lichtquellen wie LED, LARP und LERP gewinnen insbesondere in der LCD-Hinterleuchtung immer mehr an Bedeutung. Insbesondere steigt die Nachfrage nach warmweißen LEDs mit niedrigen Farbtemperaturen und guter Farbwiedergabe und gleichzeitig hoher Effizienz.

Die Leuchtstoffe müssen eine Reihe von Anforderungen erfüllen: Eine sehr hohe Stabilität gegenüber chemischen Einflüssen, beispielsweise Sauerstoff, Feuchtigkeit, Wechselwirkungen mit Vergussmaterialien, sowie gegenüber Strahlung. Um einen stabilen Farbort bei steigender Systemtemperatur zu gewährleisten, sind außerdem Leuchtstoffe erforderlich, die ein geringes Temperaturlöschverhalten aufweisen.

Derartige Leuchtstoffe werden in weißen LEDs und Color-on-Demand LEDs eingesetzt.

Die Anregung derartiger Leuchtstoffe geschieht bevorzugt mit kurzwelliger Strahlung im UV und kurzwelligen Blau, insbesondere im Bereich 360 bis 480 nm.

Die Erfindung basiert auf der Bereitstellung von Leuchtstoffen aus den Stoffklassen der Nitrido-Orthosilikate.

Es hat sich gezeigt, dass ein Unterschuss an SiO₂ bei diesen Leuchtstoffen zu höheren Quanteneffizienzen führt. Damit ergibt sich eine Zusammensetzung der Ansatzmischung für das stabilisierte Nitrido-Orthosilikat von AE₂₋ₓₐREₓEuₐSi_{1-y}O_{4-x-2y}Nₓ (AE=Sr, Ba, Ca, Mg; RE = Seltene Erdmetalle, ausgewählt aus der Gruppe La, Lu, Dy, Yb allein oder in Kombination), wobei x bevorzugt zwischen 0,002 und 0,02, a bevorzugt zwischen 0,01 und 0,2 liegt. Der für den SiO₂-Unterschuss maßgebende Faktor y liegt im Bereich zwischen 0 < y ≤ 0,1, bevorzugt im Bereich von 0,002 ≤ y ≤ 0,02. Bei dem hier beschriebenen Verfahren zur Herstellung eines stabilisierten Nitrido-Orthosilikats erweitert sich außerdem bevorzugt in einer Ausführungsform die Eduktseite um Si₃N₄ und RE₂O₃.

Für die Präparation von AE₂₋ₓ₋ₐREₓEuₐSi_{1-y}O_{4-x-2y}Nₓ benötigt man entweder AECO₃, SiO₂, REN und Eu₂O₃ oder AECO₃, SiO₂, Si₃N₄, RE₂O₃ und Eu₂O₃ als Ausgangssubstanzen. Weiterhin können insbesondere Fluoride und Chloride, wie AECl₂, AEF₂, aber auch NH₄Cl/NH₄F, H₃BO₃, LiF und Kryolithe, sowie Kombinationen davon, als Schmelzmittel eingesetzt werden.

Überraschenderweise zeigt sich, dass ein Leuchtstoff vom Typ stabilisiertes Nitrido-Orthosilikat mit ganz speziellen RE ausgewählt aus der Gruppe La, Lu, Dy, Yb allein oder in Kombination die für Halbleiter-Lichtquellen besonders kritischen Eigenschaften guter Effizienz bei Hochstrombetrieb und stabilen Alterungsverhaltens in optimaler Weise erfüllen. Dies gilt in besonderer Weise für die Anforderungen bei Lichtquellen für die LCD-Hinterleuchtung. Eine andere Anforderung ist Stabilität unter Bestrahlung mit Lasern als primärer Lichtquelle.

LCD-Hintergrundbeleuchtung gewinnt in vielen Industriesegmenten immer mehr an Bedeutung. Insbesondere steigt die Nachfrage nach flachen Bauweisen der Hintergrundbeleuchtung. Sie kann zurzeit nur mittels Halbleiter-Lichtquellen wie LED-Hintergrundbeleuchtung befriedigt werden. Außerdem steigen gleichzeitig die Anforderungen der Bauteile bezüglich Farbwiedergabe, Lebensdauer und Effizienz stetig an.

Um z.B. eine weiße LED für die Hintergrundbeleuchtung, die einen hinreichend großen Farbraum besitzt, herstellen zu können, ist es erforderlich hinreichend schmalbandige grüne und rote Leuchtstoffe einzusetzen.

Die Leuchtstoffe müssen eine Reihe von Anforderungen erfüllen, um eine hohe Lebensdauer und Effizienz zu gewährleisten: Eine sehr hohe Stabilität gegenüber chemischen Einflüssen, beispielsweise Sauerstoff, Feuchtigkeit, Wechselwirkungen mit Vergussmaterialien, sowie gegenüber Strahlung. Um einen stabilen Farbort bei steigender Systemtemperatur zu gewährleisten, sind außerdem Leuchtstoffe erforderlich, die ein geringes Temperaturlöschverhalten bei Betriebstemperatur der LED aufweisen. Insbesondere grüne schmalbandige Leuchtstoffe, die eine hinreichende chemische Stabilität aufweisen, sind am Markt zurzeit nicht kommerziell erhältlich.

Bisherige LEDs für die Hintergrundbeleuchtung werden in der Regel entweder erreicht durch:
1. eine Kombination aus einer relativ langwelligen LED mit einem gelben Leuchtstoff,
2. eine Kombination von blauer LED mit breitbandigen Grünleuchtstoffen und Rotleuchtstoffen oder
3. eine Kombination von blauer mit einem schmalbandigen Grünleuchtstoff, bevorzugt ein Orthosilikat, und einem Rotleuchtstoff.
Die erste Lösung ist zwar effizient, es kann aber ein nur sehr kleiner Farbraum abgedeckt werden. Die zweite Lösung kann ebenfalls durch die breitbandige Grünemission nur für einen schmalen RGB-Farbraum genutzt werden. Die dritte Lösung ist zwar prinzipiell für einen NTSC Farbraum > 85% geeignet, aber zeigt aufgrund des verwendeten Grünleuchtstoffs (Orthosilikat) starke LED-Alterungserscheinungen und damit auch Effizienzverluste sowie Farbortverschiebungen, da Orthosilikate nicht hinreichend chemisch stabil sind. Die Abkürzung NTSC (National Television System Committee) bezieht sich dabei auf eine hochwertige Fernsehnorm.
Die erfindungsgemäße Lösung ist erstmals für eine ausreichend stabile und effiziente Hintergrundbeleuchtung geeignet, die einen hinreichend großen NTSC Farbraum (≥ 85%) aufspannt. Sie besteht aus der Kombination einer blau-emittierenden LED mit einem neuartigen schmalbandig gelb-grün emittierenden unterstöchiometrischen Nitrido-Orthosilikats der Form AE₂₋ₓ₋ₐREₓEuₐSi_{1-y}O_{4-x-2y}Nₓ und einem schmalbandigen roten Nitridoalumosilikat-Leuchtstoff der Form AEAlSiN₃:Eu²⁺.

Beide Leuchtstoff-Typen sind ähnlich stabil und ähnlich effizient, so dass es zu keinen unerwünschten FarbortVerschiebungen kommt. Diese Entwicklung stellt einen Meilenstein hinsichtlich Halbleiter-basierter Lichtquellen, insbesondere zur Anwendung für die Hinterleuchtung von NTSCtauglichen Geräten, dar.
In diesem Zusammenhang hat sich vor allem RE = Lu, Dy, Yb allein oder in Kombination bewährt, da diese die erforderliche Hochstrom-Effizienz bereitstellen können.
Ein besonders bevorzugte Lichtquelle verwendet ein modifiziertes Orthosilikat, das eine Korngröße d₅₀ im Bereich 10 bis 30 um aufweist. Diese relativ grobe Körnung erweist sich als besonders effizient verglichen mit feinerer Körnung, aufgrund geringerer Streueigenschaften und der damit verbundenen sehr guten Absorption im Bereich der Anregungslichtquelle. Ein weiterer vorteilhafter Parameter des modifizierten Orthosilikats ist der Wert b₈₀, dieser sollte im Bereich ≤ 1,5 liegen, um eine schmale Korngrößenverteilung zu gewährleisten, was ebenfalls die Effizienz und das Streuverhalten verbessert. Durch einen kleinen Wert b80=(d90-d10)/d50, also sehr schmale Kornverteilungen, wird die daraus resultierende Streuung nahezu konstant gehalten. Dies ist wichtig z.B. für die Farbortsteuerung in einer LED. Bei sehr breiten Kornverteilungen mit b80 größer 1,5 ist die Streuung sehr unterschiedlich, je nach Korngrößenanteilen, und damit sind auch die daraus resultierenden Farborte unterschiedlich.
Der Anteil SiO₂ ist hier besonders kritisch. Die Langzeitstabilität der Lichtquelle, die das REN-stabilisierte Orthosilikat verwendet, verbessert sich dabei um mindestens 20% bis hin zu weit über 50%, je nach Umfang der Abweichung von der Stöchiometrie. Der Anteil y des RE bezogen auf M, sollte bevorzugt im Bereich von 0,2 bis 5 % liegen, je nach Anwendungsbereich kann dieser Anteil auch noch höher gewählt werden, sollte aber 10% nicht übersteigen. Gute Ergebnisse werden mit y = 0,25 bis 1% erzielt.
Der Leuchtstoff vom Typ modifiziertes Orthosilikat ist bevorzugt in Gießharz eingebettet und auf einer LED aufgebracht, bzw. als Keramik einer LED oder auch Laserdiode vorgeschaltet (LERP und LARP-Anwendung).
Bei Verwendung von Gießharz kann dieses auf der LED mittels chip level conversion, Sedimentation oder Volumenguss aufgebracht sein. Dabei wird vorzugsweise ein Füllmaterial mit einem Anteil von 1 bis 50 Gew.-% am Gießharz verwendet. Das Füllmaterial ist bevorzugt SiO₂, insbesondere mit Korngröße d50 zwischen 3 und 7 um. Weitere Bestandteile sind insbesondere Silikon.
Der Leuchtstoff ist grün emittierend und hat die Formel AE_{(2-x-y)}REₓEu_{y}Si₍₁₋ₛ₎O(₄₋₂ₛ₋ₓ)Nₓ. AE ist Ba,Sr,Ca allein oder in Kombination, RE ist Lu,La,Dy,Yb allein oder in Kombination, wobei 0 < x < 0,1 sowie 0 < y < 0,2. Der besondere Wert derartiger Leuchtstoffe liegt darin, dass sie sehr schmalbandig emittieren, so dass sie die konkurrierende, aber sehr aufwendige Lösung mit drei farbig emittierenden LEDs vom Typ RGB ersetzen können. Grundsätzlich sind nur sehr wenige Leuchtstoffe schmalbandig genug, um für diese Anforderungen geeignet zu sein, noch dazu in der stark belasteten Umgebung einer Halbleiter-Lichtquelle als primäre Lichtquelle. Derartige Leuchtstoffe werden im folgenden auch als NOS, Nitrido-Orthosilikate, bezeichnet, wobei die Modifizierung mit Seltenen Erden RE auf Basis einer Nitrid-Zugabe REN als Dotierung mit der Seltenen Erde RE ausgedrückt wird, beispielsweise NOS:RE.

Ein bevorzugter zusätzlicher rot emittierender Leuchtstoff ist CAlSiN:Eu, insbesondere ist es ein modifizierter Leuchtstoff mit der Beschränkung AE(1-z)EuzAlSiN(3-0,67t)Ot wobei 0 < z < 0,1 und 0 < t < 0,1 mit AE = Ca, Sr allein oder in Kombination. Der besondere Wert dieser Kombination liegt darin, dass diese Leuchtstoffe ähnlich schmalbandig emittieren wie der neuartige grün emittierende Leuchtstoff. Damit steht eine technische Lösung für die LCD-Hinterleuchtung bereit, die die sehr aufwendige Lösung mit drei farbig emittierenden LEDs vom Typ RGB ersetzten kann. Grundsätzlich sind nur sehr wenige Leuchtstoffe schmalbandig genug, um für diese Anforderungen geeignet zu sein, noch dazu in der stark belasteten Umgebung einer Halbleiter-Lichtquelle als primäre Lichtquelle. Schmalbandig heißt hier, dass beide Leuchtstoffe, der grün und der rot emittierende, eine FWHM von maximal 95 nm aufweisen.

Die besondere Herausforderung bei LCD-Lösungen ist die Anpassung an die dabei verwendeten grünen und roten Farbfilter. Übliche grün emittierende Leuchtstoffe, die hier Verwendung finden, haben eine Peakemission bei 540 nm und sind wenig flexibel. Daher ist es schwierig damit einen hohen Farb-Gamut zu erzielen, weil die üblichen Farbfilter auf ein grünes Maximum von 515 bis 535 nm angepasst sind. Verwendet man übliche Orthosilikate, so kann die Peakemission zwar gezielt in diesen Fensterbereich gebracht werden, aber es kommt bald zu Farbverschiebungen aufgrund der hohen Betriebstemperaturen und die Farbhomogenität lässt zu wünschen übrig.

Eine Beleuchtungseinheit gemäß der Erfindung beinhaltet neben der Lichtquelle mindestens ein Farbfilter mit einem Maximum im Bereich 625 bis 655 nm. Bevorzugt wird ein zweites Farbfilter für den grünen Bereich mit einem Maximum zwischen 515 und 535 nm eingesetzt. Bevorzugt ist insbesondere eine Lösung mit drei Farbfilter, einem blauen Farbfilter mit einem Maximum zwischen 435 und 455 nm, einem grünen Farbfilter mit gung. Das erschwert den Ei und 535 nm und einem roten Farbfilter mit einem Maximum von 625 bis 655 nm.

Hier ist der neuartige grün emittierende Leuchtstoff des Typs modifiziertes Orthosilikat wesentlich besser angepasst und insbesondere schmalbandig genug. Die FWHM des neuartigen Leuchtstoffs liegt typisch bei 60 bis 90 nm, ähnlich wie dies auch ein dazu passender Calsin-Leuchtstoff zeigt. Der Peak der Emission des modifizierten Leuchtstoffs lässt sich variabel auf 515 bis 535 nm durch geeignete Zusammensetzung einstellen, wodurch er optimal auf übliche Farbfilter angepasst ist. Die Kombination aus geeigneter blauer Halbleiter-Primärlichtquelle, LED oder Laserdiode, mit Peakemission 430 bis 460 nm, mit teilweiser Konversion des Primärlichts durch ein modifiziertes grün emittierendes Nitrido-Orthosilikat mit Peakemission im Bereich 510 bis 540 nm und mit teilweiser Konversion des Primärlichts durch einen rot emittierenden Leuchtstoff, AEAlSiN3:Eu, evtl. modifiziert, zeigt einen hohen Farb-Gamut und hohe Helligkeit, auch bei Verwendung der üblichen Farbfilter. Die Effizienz bleibt über die Lebensdauer konstant hoch.

Ein geeignetes Füllmaterial, das zusammen mit diesen Leuchtstoffen in Gießharz verwendet wird, ist SiO2, das nahezu transparent ist für Licht, bezogen auf Raumtemperatur. Eine Alternative ist Al2O3. Daher treten dabei keine Helligkeitsverluste bei Raumtemperatur auf. Bei höheren Betriebstemperaturen ergibt sich eine Brechungsindex-Differenz zwischen dem Füllmaterial und dem Gießharz, wodurch die Streuung sich verstärkt. Dadurch werden FarbVerschiebungen minimiert und die Farbhomogenität verbessert, wenn die Betriebstemperatur erreicht ist.

Statt Gießharz kann auch ein anderes Medium wie Silikon oder Glas verwendet werden. Der Leuchtstoff bzw. die Mischung kann ggf. auch direkt auf den Chip aufgebracht werden oder beabstandet davon, beispielsweise in einer Platte aus Glas oder Keramik.

Je nach gewähltem Farbraum und dabei angewendetem Farbfilter können auch andere Seltenerdmetalle Anwendung finden oder zu Yb, Dy, La oder Lu als Beifügung verwendet werden. Dies gilt vor allem für Ho, Er und Tm.

Je nach Anwendung können auch andere Aktivierungsmetalle außer Eu Anwendung finden. Bevorzugte Alternativen sind Ce oder Mn. Diese können insbesondere auch neben Eu als Ko-Dotierung verwendet werden. Im allgemeinen ist ihr Anteil dann bevorzugt maximal 30% am Aktivator D neben Eu.

Während NOS:La chemisch außerordentlich stabil ist, nimmt dessen Effizienz bei sehr hohen Vorwärtsströmen in einer LED ab. Je höher die Umgebungstemperatur, desto geringer wird überraschenderweise dieser nachteilige Effekt. Dagegen zeigen NOS:Lu, NOS:Yb und NOS:Dy etwas weniger chemische Stabilität, aber sehr gute Konstanz der Effizienz bei hohen Vorwärtsströmen.

Die stabilisierende Wirkung des REN tritt bereits bei kleinen Konzentrationen von 0,025% am NOS:RE auf, dieser Stabilisierungseffekt bleibt bis mindestens zu einer Konzentration von 0,25% am NOS:RE erhalten.

Bevorzugte Konzentrationen der Aktivierung sind 2 bis 10% bezogen auf M, das im wesentlichen AE und RE ist.

### Kurze Beschreibung der Zeichnungen

Im Folgenden soll die Erfindung anhand mehrerer Ausführungsbeispiele näher erläutert werden. Die Figuren zeigen:
Fig. 1 eine Konversions-LED;
Fig. 2 ein LED-Modul mit entfernt angebrachter Leuchtstoffmischung;
Fig. 3 ein Emissionsspektrum einer LCD-Backlight-LED mit einer Mischung aus einem grünen Leuchtstoff des Typs (Sr,Ba)₂Si_{1-y}O_{4-x-2y}Nₓ:Eu, Lu und einem roten Leuchtstoff des Typs Alumonitridosilikat CaAlSiN₃:Eu²⁺
Fig. 4 einen Vergleich des Farbraums NTSC und dem von einer LED gemäß Figur 3 aufgespannten Farbraum;
Fig. 5 einen Vergleich des von verschieden dotierten LEDs aufgespannten Farbraums relativ zum Farbraum NTSC;
Figur 6 die Effizienz verschiedener Leuchtstoffe im Betrieb einer LED unter Niederstrom- und Hochstrom-Bedingungen;
Figur 7 der Effizienzverlust nach 1000h eines Lu-dotierten NOS unter harschen Bedingungen, die die chemische Stabilität herausfordern;
Figur 8 der Effizienzverlust nach 1000h eines Yb-dotierten NOS unter harschen Bedingungen, die die chemische Stabilität herausfordern;
Figur 9 der Effizienzverlust nach 1000h eines Dy-dotierten NOS unter harschen Bedingungen, die die chemische Stabilität herausfordern;
Figur 10 der Effizienzverlust nach 1000h eines La-dotierten NOS unter harschen Bedingungen, die die chemische Stabilität herausfordern;
Figur 11 der Effizienzverlust nach 1000h eines geringfügig La-dotierten NOS unter harschen Bedingungen, die die chemische Stabilität herausfordern;
Figur 12 die Darstellung verschiedener Farbräume unter Einbezug von NTSC;
Figur 13 eine Darstellung einer Lampe mit Leuchtstoff;
Figur 14 eine Darstellung des Einflusses von SiO₂ auf die Stabilisierung des Farborts.

### Bevorzugte Ausführungsform der Erfindung

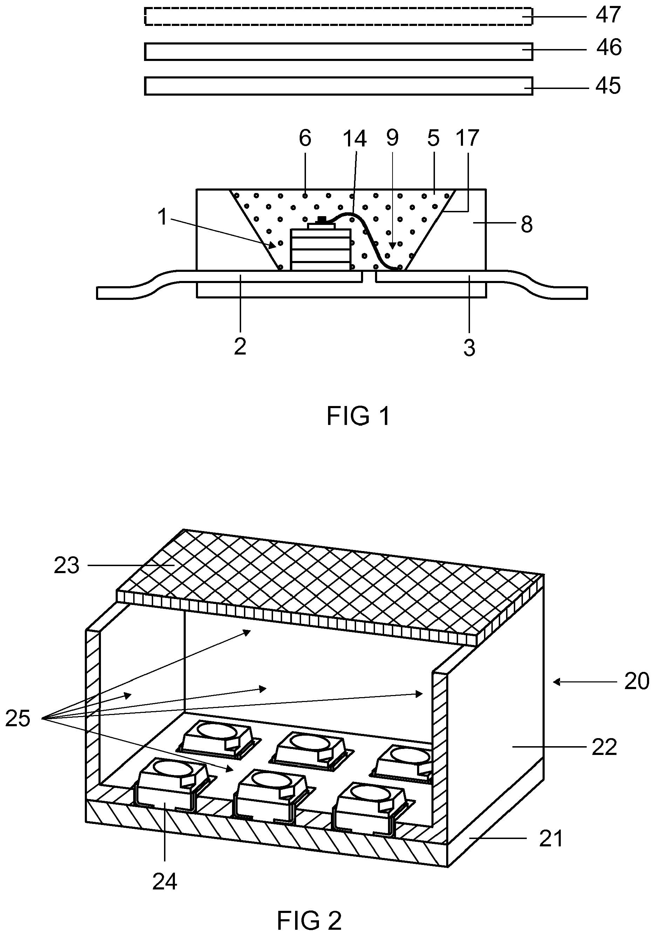

Figur 1 zeigt den Aufbau einer Konversions-LED für weißes Licht auf RGB-Basis wie an sich bekannt. Die Lichtquelle ist ein Halbleiterbauelement mit einem blau emittierende Chip 1 des Typs InGaN mit einer Peakemissionswellenlänge von 435 bis 455 nm Peakwellenlänge, beispielsweise 445 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (60- 90 Gew.-%) und Leuchtstoffe 6 (etwa 15 bis 40 Gew.-%) enthält. Ein erster Leuchtstoff ist ein grün emittierender Nitrido-Orthosilikat-Leuchtstoff AE₂₋ₓ₋ₐREₓEuₐSi_{1-y}O_{4-x-2y}Nₓ mit AE ist Ba,Sr und mit RE ist Lu. Andere Ausführungsbeispiele verwenden zumindest eines der folgenden Elemente: für AE = Ba,Sr,Ca,Mg und für RE = Dy,Yb,La. Außerdem wird als zweiter Leuchtstoff ein rot emittierender Leuchtstoff, beispielsweise ein Alumonitridosilikat oder CAlSiN verwendet. Die Ausnehmung hat eine Wand 17, die als Reflektor für die Primär- und Sekundärstrahlung vom Chip 1 bzw. den Leuchtstoffen 6 dient. Konkrete Ausführungsbeispiele für weitere Leuchtstoffe sind zur Erzeugung von Weiß ein durch Cu oder Sauerstoff modifiziertes CaAlSiN₃:Eu oder ein (Ca,Sr)AlSiN₃:Eu.

Grundsätzlich ist die Verwendung der Leuchtstoff-Mischung als Dispersion, als Dünnfilm, etc. direkt auf der LED oder auch, wie an sich bekannt, auf einem separaten, der LED vorgeschalteten Träger möglich.

Eine Beleuchtungseinheit umfasst weiterhin auch ein grünes Farbfilter 45, ein rotes Farbfilter 46 und ggf. ein blaues Farbfilter 47, die der LED vorgelagert sind.

Figur 2 zeigt ein derartiges Modul 20 mit diversen LEDs 24 auf einer Grundplatte 21. Darüber ist ein Gehäuse montiert mit Seitenwänden 22 und einer Deckplatte 12. Die Leuchtstoff-Mischung ist hier als Schicht 25 sowohl auf den Seitenwänden als auch vor allem auf der Deckplatte 23, die transparent ist, angebracht.

Andere geeignete Lichtquellen sind Leuchtstofflampen oder Hochdruckentladungslampen, bei denen der neuartige Leuchtstoff zur Konversion der primären Strahlung herangezogen werden kann, allein oder in Kombination mit anderen Leuchtstoffen. Diese Leuchtstoffe sind üblicherweise an der Wand eines Kolbens der Lampe angebracht.

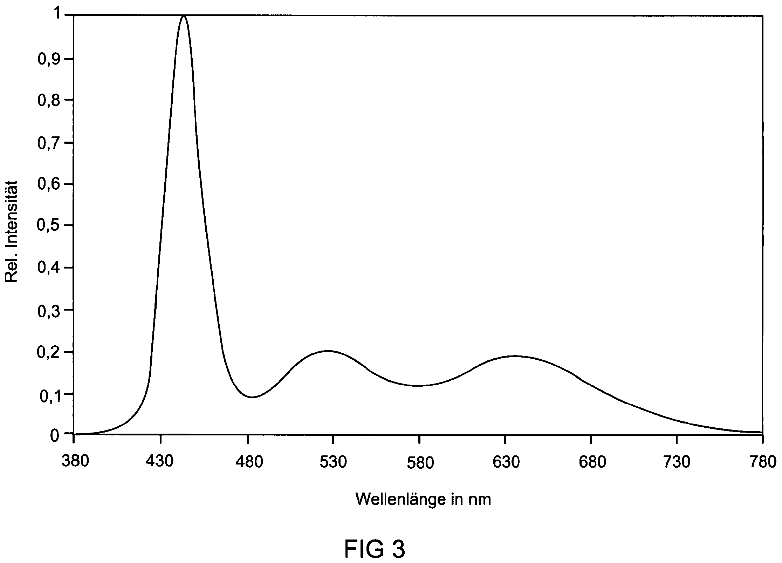

Figur 3 zeigt das Spektrum einer konvertierenden LCD-Backlight-LED auf Basis zweier Leuchtstoffe. Die Anregung erfolgt durch eine primär emittierende LED mit 448 nm Peak-Wellenlänge (blau). Auf der Abszisse ist die Wellenlänge in nm, auf der Ordinate die relative Emissionsintensität aufgetragen. Ein erster eingebrachter Leuchtstoff ist ein Rotleuchtstoff des Typs CaAlSiN3:Eu, der zweite ist ein erfindungsgemäßer Grünleuchtstoff mit der Ansätzstöchiometrie (Ba,Sr)₂₋ₓ₋ₐLuₓEuₐSi_{1-y}O_{4-x-2y}Nₓ mit x = 0,005, a = 0,08 und y = 0,0075.

Die Herstellung des neuartigen unterstöchiometrischen Leuchtstoffs gelingt auf folgende Weise:

Die Edukte analog den Ansatzmischungen 1 bis 4 werden, bevorzugt zusammen mit einem geeigneten Schmelzmittel, eingewogen und homogenisiert. Anschließend wird die Eduktmischung für mehrere Stunden unter reduzierender Atmosphäre (insbesondere unter N₂ bzw. Ar oder einem Gemisch aus N₂/H₂ oder Ar/H₂) bei Temperaturen zwischen 1000°C und 1500°C geglüht. Darauf kann eine Zweitglühung, ebenfalls unter reduzierender Atmosphäre (insbesondere unter N₂ bzw. Ar oder einem Gemisch aus N₂/H₂ oder Ar/H₂) bei Temperaturen zwischen 800°C und 1400°C, erfolgen. Die Synthese wird in einem geeigneten Ofen, wie z.B. Rohroder Kammerofen durchgeführt.
a) Vergleichsbeispiel/Ansatzmischung 1 (Stand der Technik):
   73,5 g SrCO₃, 98,1 g BaCO₃, 31,1 g SiO₂ und 7,2 g Eu₂O₃;
b) Vergleichsbeispiel/Ansatzmischung 2 (Stand der Technik):
   73,3 g SrCO₃, 97,9 g BaCO₃, 31,1 g SiO₂, 0,4 g LaN und 7,2 g Eu₂O₃;
c) Ausführungsbeispiel /Ansatzmischung 3:
   73,4 g SrCO₃, 98,0 g BaCO₃, 30,8 g SiO₂, 0,1 g Si₃N₄, 0,4 g La₂O₃ und 7,2 g Eu₂O₃;
d) Ausführungsbeispiel/Ansatzmischung 4:
   73,3 g SrCO₃, 98,0 g BaCO₃, 30,9 g SiO₂, 0,4 g LaN und 7,2 g Eu₂O₃;

Bereits durch den Einbau von Lanthan und Stickstoff wie in Vergleichsbeispiel 2 ist bereits bei höheren Temperaturen und in feuchter Umgebung eine deutliche Verbesserung der LED-Stabilität zu erkennen. Für viele Anwendungen, wie z. B. für LCD-Hintergrundbeleuchtung, ist diese Stabilität jedoch immer noch nicht optimal.

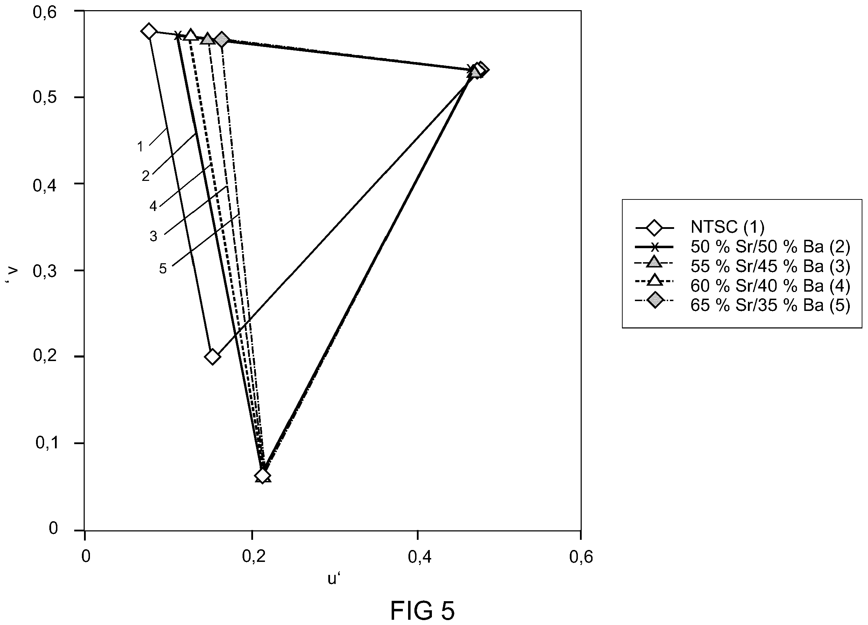

Die hier beschriebene neue Ansätzstöchiometrie gemäß Ausführungsbeispiel 3 bzw. 4 mit einem entsprechenden Unterschuss an SiO₂ führt nachweislich zu einer verbesserten LED-Stabilität, vor allem in feuchter Umgebung und bei höheren Temperaturen. In Figur 5 ist die LED-Stabilität bei einer Temperatur von 45 °C und 95% Luftfeuchtigkeit für die vier verschiedenen Ansatzmischungen dargestellt. Als Ordinate ist das relative Konversionsverhältnis aufgetragen, die Abszisse ist die Zeit in Minuten. Es zeigt sich, dass die Ausführungsbeispiele 3 und 4 etwa zueinander gleichwertig sind und beide den Vergleichsbeispielen 1 und 2 merklich überlegen sind.

Die relative Quanteneffizienzen QE₄₆₀ der neuartigen Leuchtstoffe gemäß Ausführungsbeispiel 3 und 4 bei Anregung mit 460 nm ist um 3% höher als beim Vergleichsbeispiel 2.

Die Präparation der dargestellten Nitrido-Orthosilikate der Form AE₂₋ₓ₋ₐREₓEuₐSi_{1-y}O_{4-x-2y}Nₓ erfolgt typischerweise aus AECO₃ SiO₂, REN und Eu₂O₃ oder AECO₃, SiO₂, Si₃N₄, (RE)₂O₃ und Eu₂O₃ als Ausgangssubstanzen. Im Letzteren werden die Seltenen Erden als (RE)₂O₃ eingesetzt, wenn bevorzugt dreiwertige Oxide gebildet werden. Bei Selten-Erd-Oxiden die bevorzugt als Mischoxide vorliegen wie beispielsweise Tb gewöhnlich als III/IV Mischoxid Tb₄O₇ vorliegt, werden die Mischoxide bevorzugt eingesetzt. Weiterhin können anstelle von REN oder RE-Oxid in Verbindung mit Si₃N₄, auch In, Y oder Sc als Nitrid bzw. als eine Kombination aus Oxid und Si₃N₄ eingesetzt werden.

Weiterhin können insbesondere Fluoride und Chloride, wie AECl₂ oder RECl₂, AEF₂ oder RECl₂, aber auch NH₄Cl/NH₄F, H₃BO₃, LiF und Kryolithe, sowie Kombinationen davon, als Schmelzmittel eingesetzt werden.

Die Edukte analog der Ansatzmischungen werden zusammen mit einem geeigneten Schmelzmittel eingewogen und homogenisiert. Anschließend wird die Eduktmischung für mehrere Stunden unter reduzierender Atmosphäre (z. B. unter N₂ bzw. Ar oder einem Gemisch aus N₂/H₂ oder Ar/H₂) bei Temperaturen zwischen 1000°C und 1500°C geglüht. Darauf kann eine Zweitglühung, ebenfalls unter reduzierender Atmosphäre (z. B. unter N₂ bzw. Ar oder einem Gemisch aus N₂/H₂ oder Ar/H₂) bei Temperaturen zwischen 800°C und 1400°C, erfolgen. Die Synthese wird in einem geeigneten Ofen, wie z.B. Rohr- oder Kammerofen durchgeführt.

### Ansatzmischung 1:

69,9 g SrCO₃ 93,3 g BaCO₃, 29,3 g SiO₂, 0,1 g Si₃N₄, 0,5 g La₂O₃ und 7,0 g Eu₂O₃

### Ansatzmischung 2:

69,9 g SrCO₃, 93,3 g BaCO₃, 29,3 g SiO₂, 0,1 g Si₃N₄, 0,4 g Pr₆O₁₁ und 7,0 g Eu₂O₃

### Ansatzmischung 3:

69,9 g SrCO₃, 93,3 g BaCO₃, 29,3 g SiO₂, 0,1 g Si₃N₄, 0,4 g Nd₂O₃ und 7,0 g Eu₂O₃

### Ansatzmischung 4:

69,9 g SrCO₃, 93,3 g BaCO₃, 29,3 g SiO₂, 0,1 g Si₃N₄, 0,4 g Sm₂O₃ und 7,0 g Eu₂O₃

### Ansatzmischung 5:

69,9 g SrCO₃, 93,3 g BaCO₃, 29,3 g SiO₂, 0,1 g Si₃N₄, 0,4 g Gd₂O₃ und 7,0 g Eu₂O₃

### Ansatzmischung 6:

69,9 g SrCO₃, 93,3 g BaCO, 29,3 g SiO₂, 0,1 g Si₃N₄, 0,5 g Tb₄O₇ und 7,0 g Eu₂O₃

### Ansatzmischung 7:

69,9 g SrCO₃, 93,3 g BaCO₃, 29,3 g SiO₂, 0,1 g Si₃N₄, 0,5 g Dy₂O₃ und 7,0 g Eu₂O₃

### Ansatzmischung 8:

69,9 g SrCO₃, 93,3 g BaCO₃, 29,3 g SiO₂, 0,1 g Si₃N₄, 0,5 g Ho₂O₃ und 7,0 g Eu₂O₃

### Ansatzmischung 9:

69,9 g SrCO₃, 93,3 g BaCO₃, 29,3 g SiO₂, 0,1 g Si₃N₄, 0,5 g Er₂O₃ und 7,0 g Eu₂O₃

### Ansatzmischung 10:

69,9 g SrCO₃, 93,3 g BaCO₃, 29,3 g SiO₂, 0,1 g Si₃N₄, 0,5 g Tm₂O₃ und 7,0 g Eu₂O₃

### Ansatzmischung 11:

69,9 g SrCO₃, 93,3 g BaCO₃, 29,3 g SiO₂, 0,1 g Si₃N₄, 0,5 g Yb₂O₃ und 7,0 g Eu₂O₃

### Ansatzmischung 12:

69,9 g SrCO₃, 93,3 g BaCO₃, 29,3 g SiO₂, 0,1 g Si₃N₄, 0,5 g Lu₂O₃ und 7,0 g Eu₂O₃

### Ansatzmischung 13:

69,9 g SrCO₃, 93,3 g BaCO₃, 29,3 g SiO₂, 0,1 g Si₃N₄, 0,4 g Y₂O₃ und 7,0 g Eu₂O₃

### Ansatzmischung 14:

69,9 g SrCO₃, 93,3 g BaCO₃, 29,3 g SiO₂, 0,1 g Si₃N₄, 0,2 g Sc₂O₃ und 7,0 g Eu₂O₃

### Ansatzmischung 15:

69,9 g SrCO₃, 93,3 g BaCO₃, 29,3 g SiO₂, 0,1 g Si₃N₄, 0,4 g In₂O₃ und 7,0 g Eu₂O₃

In der nachfolgenden Tabelle 1 ist ein Vergleich der spektralen Eigenschaften am Beispiel einer La/N-Dotierung mit und ohne SiO₂-Unterschuss wiedergegeben.

**Tab. 1**

| Zusammensetzung | Λ_{exc.} [nm] | x | y | Λ_{dom} [nm] | FWHM [nm] | QE [%] |
|---|---|---|---|---|---|---|
| (Ba_{0.9575}Sr_{0.9575}La_{0.005}Eu_{0.08})SiO _{3,995}N_{0.005} | 460 | 0.285 | 0.638 | 545.9 | 64.2 | 87 |
| (Ba_{0.09575}Sr_{0.9575}La_{0.005}Eu_{0.08})v | 460 | 0.285 | 0.639 | 545.9 | 64.1 | 100 |

Die spektralen Daten weiterer Ausführungsbeispiele sind in der nachfolgenden Tabelle 2 aufgeführt.

| Zusammensetzung | Λ_{exc.} [nm] | x | y | Λ_{dom} [nm] | FWHM [nm] | QE [%] |
|---|---|---|---|---|---|---|
| (Ba_{0.9575}Sr_{0.9575}La_{0.005}Eu_{0.08})Si_{0 .9925}O_{3,9875}N_{0.005} | 60 | 285 | 639 | 5.9 | 4.1 | 1.00 |
| (Ba_{0.9575}Sr_{0.9575}Pr_{0.005}Eu_{0.08})Si_{0 .9925}O_{3,9875}N_{0.005} | 60 | 288 | 636 | 6.4 | 4.4 | 0.95 |
| (Ba_{0.9575}Sr_{0.9575}Sm_{0.005}Eu_{0.08})Si_{0 .9925}O_{3,9875}N_{0.005} | 60 | 285 | 638 | 5.9 | 5.0 | 0.89 |
| (Ba_{0.9575}Sr_{0.9575}Gd_{0.00S}Eu_{0.08})Si_{0 .9925}O_{3,9875}N_{0.005} | 60 | 286 | 637 | 6.1 | 5.4 | 0.97 |
| (Ba_{0.9575}Sr_{0.9575}Tb_{0.005}Eu_{0.08})Si_{0 .9925}O_{3,9875}N_{0.005} | 60 | 290 | 637 | 6.9 | 5.2 | 1.02 |
| (Ba_{0.9575}Sr_{0.9575}Dy_{0.005}Eu_{0.08})Si_{0 .9925}O_{3,9875}N_{0.005} | 60 | 289 | 637 | 6.7 | 5.1 | 1.00 |
| (Ba_{0.9575}Sr_{0.9575}HO_{0.005}EU_{0.08})Si_{0 .9925}O_{3,9875}N_{0.005} | 60 | 292 | 635 | 7.2 | 5.7 | 0.98 |
| (Ba_{0.9575}Sr_{0.9575}Er_{0.005}Eu_{0.08})Si_{0 .9925}O_{3,9875}N_{0.005} | 60 | 297 | 632 | 8.1 | 6.5 | 0.97 |
| (Ba_{0.9575}Sr_{0.9575}Tm_{0.005}Eu_{0.08})Si_{0 .9925}O_{3,9875}N_{0.005} | 60 | 297 | 634 | 8.2 | 6.4 | 1.00 |
| (Ba_{0.9575}Sr_{0.9575}Yb_{0.005}Eu_{0.08})Si_{0 .9925}O_{3,9875}N_{0.005} | 60 | 298 | 633 | 8.3 | 7.1 | 0.98 |
| (Ba_{0.9575}Sr_{0.9575}Lu_{0.005}Eu_{0.08})Si_{0 .9925}O_{3,9875}N_{0.005} | 60 | 298 | 632 | 8.3 | 7.2 | 1.01 |
| (Ba_{0.9575}Sr_{0.9575}Y_{0.005}Eu_{0.08})Si_{0. 9925}O_{3,9875}N_{0.005} | 60 | 294 | 635 | 7.6 | 5.5 | 1.02 |
| (Ba_{0.9575}Sr_{0.9575}In_{0.005}Eu_{0.08})Si₀ | 60 | 301 | 630 | 8.8 | 8.0 | 0.99 |
| _{.9925}O_{3,9875}N_{0.005} | | | | | | |
| (Ba_{0.9575}Sr_{0.9575}Sc_{0.005}Eu_{0.08})Si_{0 .9925}O_{3,9875}N_{0.005} | 60 | 296 | 633 | 8.0 | 6.9 | 1.00 |

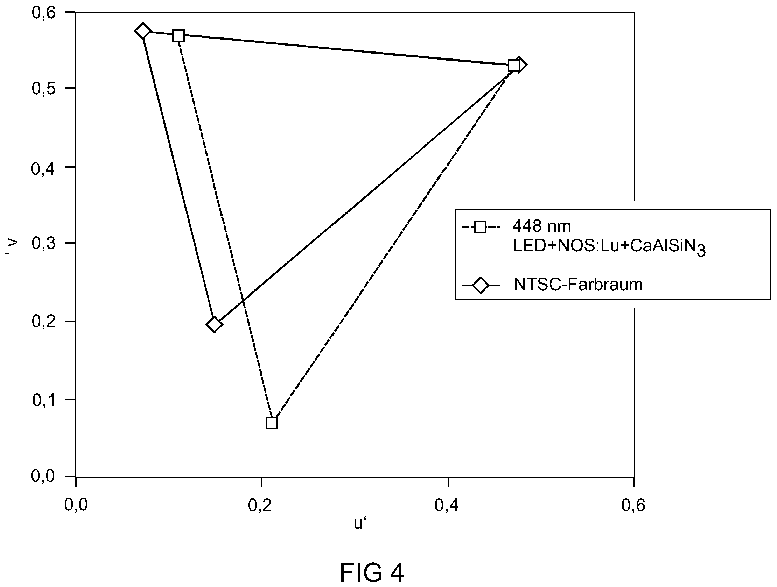

Ein Ausführungsbeispiel einer weißen LED (gemäß Aufbau aus Figur 2) mit dem zugehörigen Farbraum im Vergleich zum NTSC Farbraum ist in Figur 4 dargestellt. Die Blaukomponente wird hier durch die Primärstrahlung mit der PeakEmissionswellenlänge 448 nm der LED bereitgestellt, die Grünkomponente ist Sekundärstrahlung, basierend auf einem modifizierten Nitrido-Orthosilikat der Form (Ba_{0.9575}Sr_{0.9575}Lu_{0.005}Eu_{0.08})Si_{0.9925}O_{3,98}N_{0,005}, die Rotkomponente Sekundärstrahlung, basierend auf einem roten Nitridoalumosilikat der Form CaAlSiN₃:Eu²⁺. Das zugehörige Spektrum ist in Figur 3 dargestellt.

Um einen hinreichend großen NTSC-Farbraum > 85% aufspannen zu können, ist es nötig, den Farbort der Leuchtstoffe durch ein geeignetes AE-RE-Verhältnis anzupassen. Diese gute Anpassbarkeit ist ein besonderer Vorteil des stabilisierten NOS. Im Folgenden ist die Abhängigkeit des Farborts vom relativen Ba/Sr-Gehalt im stabilisierten Nitrido-Orthosilikat gemäß Figur 3 beispielhaft dargestellt, wobei die Farbkoordinaten u' und v' als Abszisse und Ordinate aufgetragen sind. Damit einher geht die Beeinflussung der Größe des NTSC-Farbraumes, siehe Figur 5. Der größte Farbraum wir hier mit einem relativen Verhältnis Sr/Ba von 1:1 erzielt (Kurve (2)), auch ein Verhältnis 1,1:0,9 gemäß Kurve (3) zeigt noch akzeptable Ergebnisse.

Der neue grüne Nitrido-Orthosilikat-Leuchtstoff zeigt generell gegenüber herkömmlichen grünen Orthosilikaten eine höhere chemische Stabilität, wobei das Ausmaß der Stabilisierung und die Effizienz des Leuchtstoffes bei niedrigen und hohen Strömen von der "Dotierung" mit REN abhängig sind. Dotierung meint hier die Zugabe in kleinen Mengen.

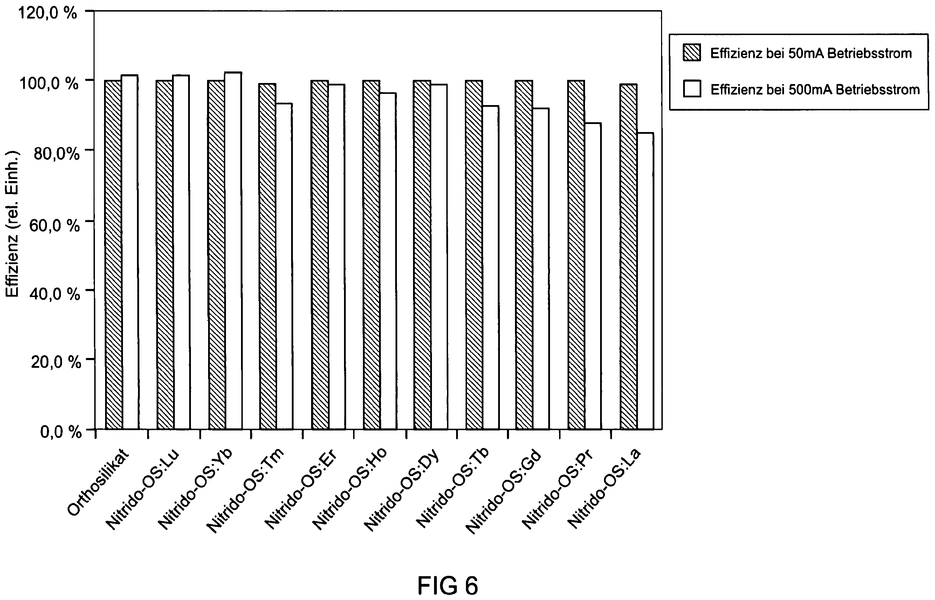

Ausführungsbeispiele des Nitrido-Orthosilikats der Form (Ba_{0.9575}Sr_{0.9575}RE_{0.005}Eu_{0.08})Si_{0.9925}O_{3,98}N_{0,005} zur Hoch- bzw. Niedrigstrom-Effizienz sind in Figur 6 dargestellt. Hochstrombetrieb bedeutet dabei typisch 500 mA, allgemeiner mindestens 200 mA bis hin zu 700 mA. Niedrigstrombetrieb bedeutet typisch 50 mA, allgemeiner 30 mA bis hin zu 150 mA. Hier zeigen Lu und Yb als RE-Dotierung die besten Ergebnisse. Das Vergleichsbeispiel Orthosilikat bedeutet BaSrSiO4:Eu als Orthosilikat ohne REN-Dotierung, die anderen Leuchtstoff sind mit REN stabilisierte Leuchtstoffe des gleichen Typs, wobei RE jeweils das angegebene Element bedeutet. Eine Zugabe von Lu und Yb sind dem reinen Orthosilikat in der Hochstromeignung mindestens ebenbürtig, mit dem zusätzlichen Vorteil der Farbort-Anpassung.

Die Präparation der dargestellten Nitrido-Orthosilikate der Form AE₂₋ₓ₋ₐREₓEuₐSiO₄Nₓ, siehe auch US 7 489 073, oder AE₂₋ₓ₋ₐREₓEuₐSi_{1-y}O_{4-x-2y}Nₓ erfolgt typischerweise aus AECO₃, SiO₂, REN und Eu₂O₃ oder AECO₃, SiO₂, Si₃N₄, (RE)₂O₃ und Eu₂O₃ als Ausgangssubstanzen. Im Letzteren werden die Seltenen Erden als (RE)₂O₃ eingesetzt, wenn bevorzugt dreiwertige Oxide gebildet werden. Bei Selten-Erd-Oxiden, die bevorzugt als Mischoxide vorliegen, wie beispielsweise Tb gewöhnlich als III/IV-Mischoxid Tb₄O₇ vorliegt, werden die Mischoxide bevorzugt eingesetzt.

Weiterhin können insbesondere Fluoride und Chloride, wie AECl₂ oder RECl₂ AEF₂ oder RECl₂, aber auch NH₄Cl/NH₄F, H₃BO₃, LiF und Kryolithe, sowie Kombinationen davon, als Schmelzmittel eingesetzt werden.

Die Edukte analog der Ansatzmischungen 1 bis 12 werden zusammen mit einem geeigneten Schmelzmittel eingewogen und homogenisiert. Anschließend wird die Eduktmischung für mehrere Stunden unter reduzierender Atmosphäre (z. B. unter N₂ bzw. Ar oder einem Gemisch aus N₂/H₂ oder Ar/H₂) bei Temperaturen zwischen 1000°C und 1500°C geglüht. Darauf kann eine Zweitglühung, ebenfalls unter reduzierender Atmosphäre (z. B. unter N₂ bzw. Ar oder einem Gemisch aus N₂/H₂ oder Ar/H₂) bei Temperaturen zwischen 800°C und 1400°C, erfolgen. Die Synthese wird in einem geeigneten Ofen, wie z.B. Rohr- oder Kammerofen durchgeführt.

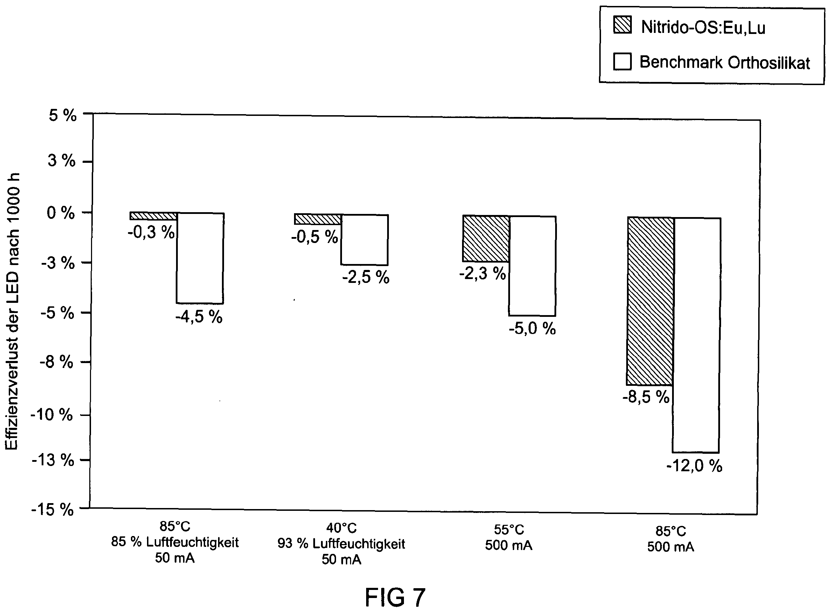

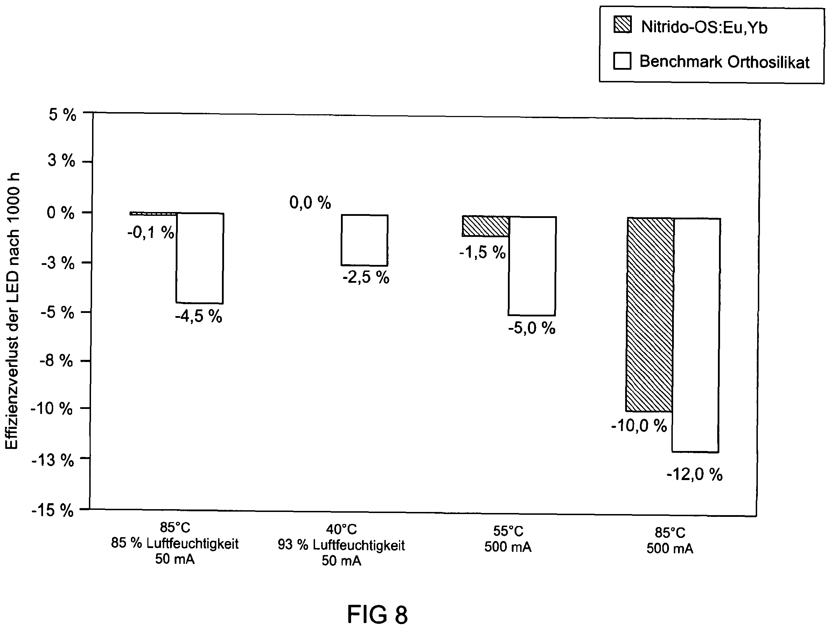

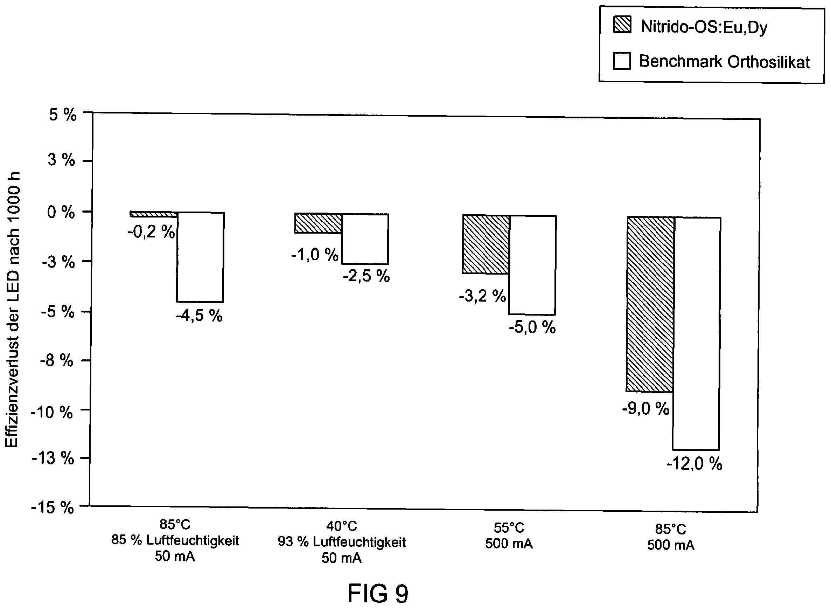

Hierbei werden drei Varianten des Nitrido-Orthosilikat-Leuchtstoffes der Form AE₂₋ₓ₋ₐREₓEuₐSi_{1-y}O_{4-x-2y}Nₓ aufgrund ihres Verhaltens bei der kombinierten Betrachtung von Alterungsstabilität und Effizienz bevorzugt. Beide Aspekte sind für eine Beleuchtungseinheit für LCD-Hinterleuchtung gleichermaßen bedeutend.
1. Ein Nitrido-Orthosilikat der Ausführung AE₂₋ₓ₋ₐLuₓEuₐSi_{1-y}O_{4-x-2y}Nₓ, welches eine höhere chemische Stabilität im Vergleich zu kommerziellen Orthosilikaten aufweist, siehe dazu Figur 7 und sowohl bei niedrigen Strömen als auch bei hohen LED-Strömen vergleichbare Effizienz zeigt, siehe dazu Figur 6. Als Benchmark ist normales Orthosilikat ohne REN aber sonst gleicher Zusammensetzung gewählt. Das dargestellte NOS:Lu ist (Ba_{0.9575}Sr_{0.9575}Lu_{0.005}Eu_{0.08})Si_{0.9925}O_{3,98}N_{0,005} unter blauer primärer Anregung bei 447 nm.
2. Ein Nitrido-Orthosilikat der Ausführung AE₂₋ₓ₋ₐYbₓEuₐSi_{1-y}O_{4-x-2y}Nₓ, welches eine höhere chemische Stabilität in der LED gegenüber herkömmlichen Orthosilikaten aufweist, siehe dazu Figur 8, und sowohl bei niedrigen Strömen als auch bei hohen LED-Strömen vergleichbare Effizienz zeigt, siehe dazu Figur 6. Das dargestellt NOS:Yb ist (Ba_{0.9575}Sr_{0.9575}Yb_{0.005}Eu_{0.08})Si_{0.9925}O_{3,98}N_{0,005} unter blauer primärer Anregung bei 448 nm.
3. Ein Nitrido-Orthosilikat der Ausführung AE₂₋ₓ₋ₐDyₓEuₐSi_{1-y}O_{4-x-2y}Nₓ, welches eine höhere chemische Stabilität in der LED gegenüber herkömmlichen Orthosilikaten aufweist, siehe dazu Figur 9, und bei niedrigen Strömen vergleichbare, bei hohen LED-Strömen nahezu vergleichbare Effizienz zeigt, siehe dazu Figur 6. Das dargestellt NOS:Dy ist (Ba_{0.9575}Sr_{0.9575}Dy_{0.005}Eu_{0.08})Si_{0.9925}O_{3,98}N_{0,005} unter blauer primärer Anregung bei 447 nm.

Die Eigenschaften der oben beschriebenen Leuchtstoffkombinationen erlauben die Realisierung einer Abdeckung von mindestens 85% des NTSC Farbraums bei sehr guter Alterungsstabilität und Effizienz.

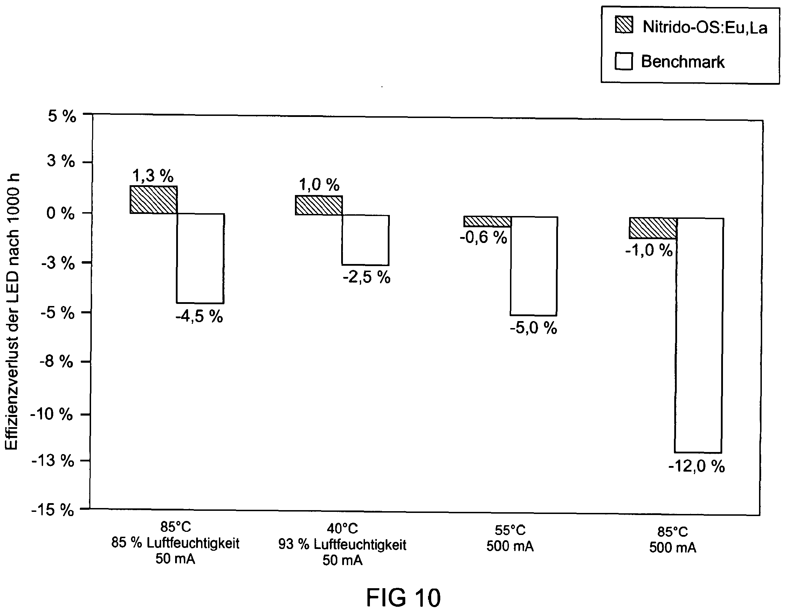

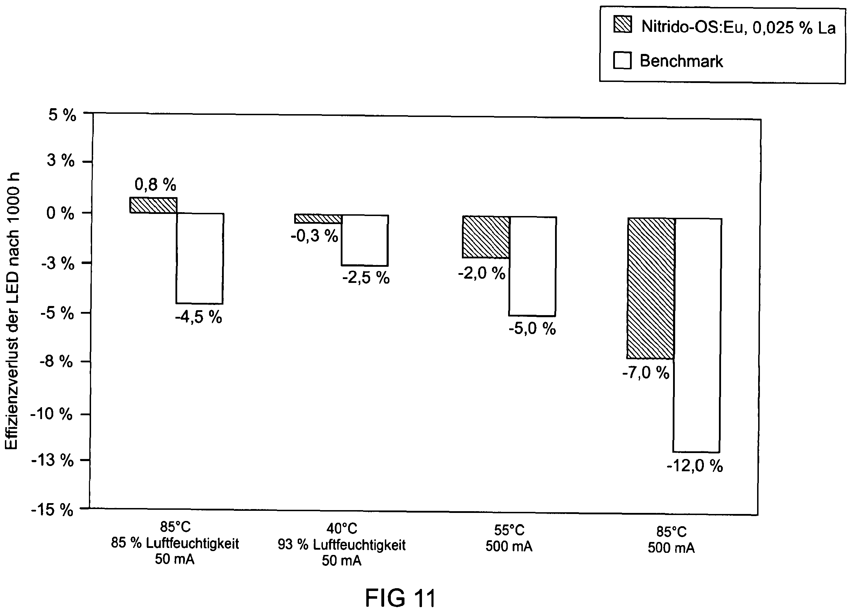

Für Applikationen, die hohe chemische Stabilitätsansprüche stellen, kann bevorzugt ein Nitrido-Orthosilikat der Ausführung AE₂₋ₓ₋ₐLaₓEuₐSi_{1-y}O_{4-x-2y}Nₓ, welches eine extrem hohe chemische Stabilität in der LED gegenüber herkömmlichen Orthosilikaten aufweist, eingesetzt werden, siehe dazu Figur 10 und Figur 11 für verschiedene Anteile La, mit vergleichbarer Effizienz bei niedrigen Betriebsströmen, siehe Figur 6. das in Figur 10 dargestellte NOS:La ist (Ba_{0.9575}Sr_{0.9575}La_{0.005}Eu_{0.08})Si_{0.9925}O_{3,98}N_{0,005} unter blauer primärer Anregung bei 447 nm. In Figur 11 ist der La-Anteil 0,0025.

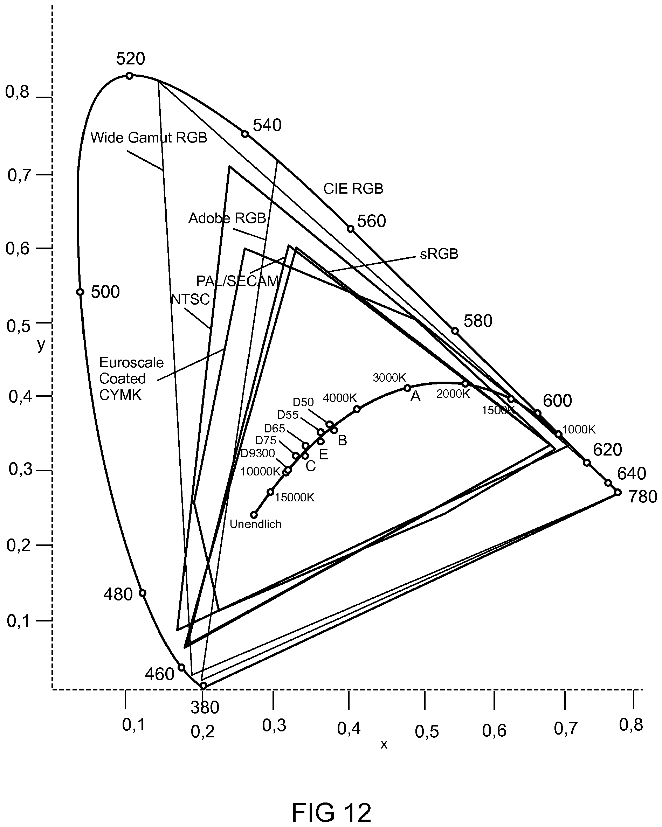

Schließlich zeigt Figur 12 einen Vergleich der verschiedenen derzeit verwendeten Farbräume. Dabei ist NTSC einer der größten überhaupt definierten Farbräume. Entsprechend schwer ist er mit technischen Lösungen darzustellen. Je größer der Überlapp mit diesem Farbraum durch eine technische Lösung ist, desto mehr Farben können damit beispielsweise auf einem Fernseher dargestellt werden.

Der Begriff 85% NTSC bedeutet, dass mit einer entsprechenden Lichtquelle, nämlich einer Kombination aus LED (blau) und zwei Leuchtstoffen (rot und grün) nach Filterung durch die roten und grünen Farbfilter 85% dieses Farbraums flächenmäßig abgedeckt werden können. Für einen derart großen Farbraum benötigt man ungewöhnlich schmalbandige Leuchtstoffe, die bevorzugt nur eine FWHM von 70 nm und weniger besitzen. Daher können für die Realisierung des NTSC-Farbraums die allermeisten Leuchtstoffe nicht eingesetzt werden, insbesondere beispielsweise keine Granate oder modifizierte Granate. Ein Beispiel ist die mögliche Verwendung von LuAGaG:Ce, der wegen seiner fehlenden Schmalbandigkeit nur für den sehr viel kleineren Farbraum sRGB (in Figur 12 dargestellt) eingesetzt werden kann, aber keinesfalls für den NTSC-Farbraum.

Überraschenderweise gelingt die zuverlässige Realisierung bisher nur mit ausgewählten modifizierten Nitrido-Orthosilikaten, sofern RE als Lu, Dy, La oder Yb oder eine Kombination daraus ausgewählt ist.

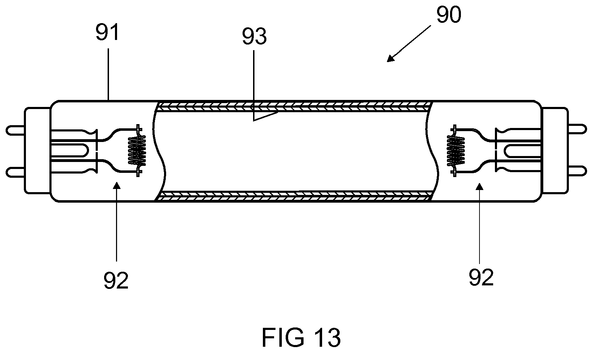

Figur 13 zeigt eine Leuchtstofflampe 90 mit einem Kolben 91 und zwei Elektroden 92. Sie enthält eine übliche Füllung, die Quecksilber aufweist, und eine Leuchtstoff-Schicht 93 unter Einbeziehung eines NOS-Leuchtstoffs mit Ansatz-Stöchiometrie der Formel EA₂₋ₓ₋ₐReₓEuₐSi_{1-y}O_{4-x-2y}Nₓ.

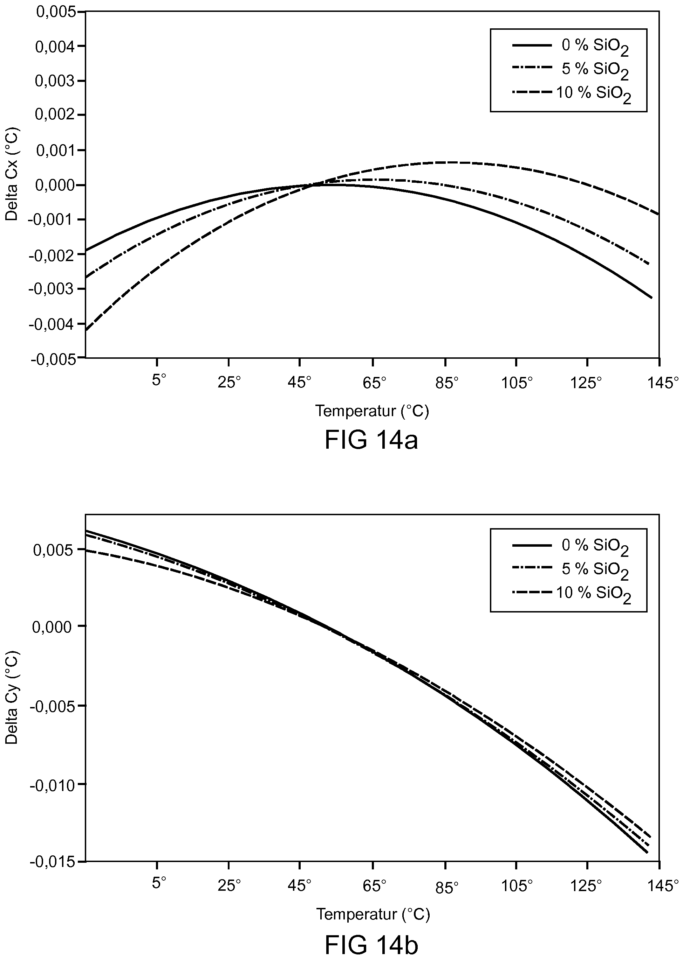

Figur 14 zeigt den Einfluss von SiO₂ als Füllmaterial im Vergussmaterial auf die Stabilisierung des Farborts als Funktion der Temperatur. Mit einem Anteil von 10 Gew.-% SiO₂ gelingt es im gezeigten Ausführungsbeispiel, die Farbortverschiebung, was die x-Koordinate betrifft, in einem Temperaturbereich von 25°C bis 145°C unter 0,001 zu halten. Die y-Koordinate lässt sich schlechter stabilisieren, jedoch hat auch hier SiO₂ einen positiven Einfluss. Empfehlenswert ist vor allem ein Anteil von SiO₂ im Bereich 5 bis 15%. Weitere Bestandteile des Vergussmaterials sind im wesentlichen Silikon und Leuchtstoff.

## Patentansprüche

1. Beleuchtungseinheit für eine LCD-Hinterleuchtung mit
- mindestens einem Farbfilter,
- einer Lichtquelle mit einer primären Strahlungsquelle, die Strahlung im kurzwelligen Bereich des optischen Spektralbereichs im Wellenlängenbereich 420 bis 480 nm emittiert, und
- zumindest einem ersten Leuchtstoff, der diese Strahlung ganz oder teilweise in sekundäre längerwellige Strahlung im sichtbaren Spektralbereich konvertiert, wobei der erste Leuchtstoff aus der Klasse der nitridisch modifizierten Orthosilikate (NOS) stammt, der aus der Struktur M₂SiO₄:D abgeleitet ist, und dieses Orthosilikat ein mit RE und N stabilisiertes Orthosilikat ist, so dass die Ansatz-Stöchiometrie der Formel EA₂₋ₓ₋ₐREₓEuₐSi_{1-y}O_{4-x-2y}Nₓ entspricht, wobei,
- der Leuchtstoff als Komponente M überwiegend die Gruppe EA = Sr, Ba, Ca oder Mg allein oder in Kombination aufweist
- die aktivierende Dotierung D zumindest aus Eu besteht und einen Anteil von M ersetzt,
- ein Anteil SiO₂ im Unterschuss eingebracht ist und der für den Unterschuss maßgebende Faktor y im Bereich von 0 < y ≤ 0,1 liegt,
- der Anteil a des Eu zwischen a = 0,01 und 0,20 beträgt,
- der Anteil x zwischen 0,002 und 0,02 beträgt,- RE = La oder Lu oder Dy oder Yb allein oder in Kombination, und
- die Halbwertsbreite FWHM des ersten Leuchtstoffs höchstens 90 nm beträgt.

2. Beleuchtungseinheit nach Anspruch 1, **dadurch gekennzeichnet, dass** EA Sr und Ba zusammengenommen mit mindestens 66 mol-% enthält, mit einem Anteil des Ca von maximal 5 mol-% und mit einem Anteil des Mg von maximal 30 mol-%,
wobei EA eine Mischung aus Sr und Ba ist mit Sr/Ba = 0,3 bis 2,3, bevorzugt eine Mischung aus Sr und Ba ist mit Sr/Ba =0,8 bis 1,2, und besonders bevorzugt eine Mischung aus Sr und Ba ist mit Sr/Ba = 0,9 bis 1,1.

3. Beleuchtungseinheit nach Anspruch 1, **dadurch gekennzeichnet, dass** der für den Unterschuss maßgebende Faktor y im Bereich von 0,002 ≤ y ≤ 0,02 liegt.

4. Beleuchtungseinheit nach Anspruch 1, **dadurch gekennzeichnet, dass** die primäre Strahlungsquelle Strahlung im Blauen im Wellenlängenbereich 440 bis 470 nm emittiert,
wobei diese Strahlung mittels des ersten Leuchtstoffs teilweise in sekundäre grüne Strahlung im sichtbaren Spektralbereich konvertiert wird, mit einer Peakemission im Bereich 510 bis 540 nm.

5. Beleuchtungseinheit nach Anspruch 4, **dadurch gekennzeichnet,**
**dass** als primäre Strahlungsquelle eine Leuchtdiode auf Basis von InGaN oder InGaAlP verwendet wird.

6. Beleuchtungseinheit nach Anspruch 4, **dadurch gekennzeichnet, dass** ein Teil der primären Strahlung weiterhin mittels weiterer Leuchtstoffe in längerwellige Strahlung konvertiert wird, wobei mindestens ein Leuchtstoff eine FWHM von höchstens 90 nm aufweist.

7. Beleuchtungseinheit nach Anspruch 6, **dadurch gekennzeichnet, dass** ein zweiter Leuchtstoff der Lichtquelle vorgeschaltet ist, der rot emittiert und aus der Klasse AEAlSiN₃:Eu stammt, mit AE = Ca und/oder Sr, allein oder in Kombination.

8. Beleuchtungseinheit nach einem der vorhergehenden Ansprüche, wobei die Lichtquelle zusammen mit drei Farbfiltern verwendet wird, wobei die Lichtquelle und die Farbfilter so aufeinander abgestimmt sind, dass ein vordefinierter Farbraum zu mindestens 85% abgedeckt ist, wobei der Farbraum NTSC ist.

9. Beleuchtungseinheit nach einem der vorhergehenden Ansprüche, wobei die Lichtquelle zusammen mit mindestens einem Farbfilter für den roten Spektralbereich mit einem Maximum im Bereich von 625 bis 655 nm, zusammen mit einem Farbfilter für den grünen Spektralbereich mit einem Maximum im Bereich 515 bis 535 nm und zusammen mit einem Filter für den blauen Spektralbereich mit einem Maximum zwischen 435 bis 455 nm verwendet wird.

## Claims

1. An illumination unit for LCD backlighting, with
- at least one color filter,
- a light source with a primary radiation source, which emits radiation in the shortwave range of the optical spectral range in the wavelength range of 420 to 480 nm, and
- at least a first luminescent substance, which converts this radiation entirely or partially into secondary longer-wave radiation in the visible spectral range, wherein the first luminescent substance originates from the class of nitridic modified orthosilicates (NOS), which is derived from the structure M₂SiO₄:D, and this orthosilicate is an orthosilicate stabilized with RE and N, where RE = rare earth metal, so that the batch stoichiometry corresponds to the formula EA₂₋ₓ₋ₐREₓEu_{aS}i_{1-y}O_{4-x-2y}Nₓ, wherein
- the luminescent substance has as a component M predominantly the group EA = Sr, Ba, Ca, or Mg alone or in combination,
- the activating dopant D is composed at least of Eu and replaces a proportion of M,
- a proportion of SiO₂ is introduced in deficiency and the factor y, which is decisive for the deficiency, is in the range of 0 < y ≤ 0.1,
- the proportion a of the Eu is between a = 0.01 and 0.20,
- the proportion x is between 0.002 and 0.02,
- RE = La or Lu or Dy or Yb alone or in combination, and
- the full width at half maximum FWHM of the first luminescent substance is at most 90 nm.

2. The illumination unit according to claim 1 , **characterized in that** EA contains Sr and Ba together with at least 66 mol-%, with a proportion of Ca of at most 5 mol% and a proportion of Mg of at most 30 mol%, wherein EA is a mixture of Sr and Ba with Sr/Ba = 0.3 to 2.3, preferably a mixture of Sr and Ba with Sr/Ba = 0.8 to 1.2, and particularly preferably a mixture of Sr and Ba with Sr/Ba = 0.9 to 1.1.

3. The illumination unit according to claim 1, **characterized in that** the factor y, which is decisive for the deficiency, is in the range of 0.002 ≤ y ≤ 0.02.

4. The illumination unit according to claim 1, **characterized in that** the primary radiation source emits radiation in the blue in the wavelength range of 440 to 470 nm, wherein this radiation is partially converted by means of the first luminescent substance into secondary green radiation in the visible spectral range, having peak emission in the range of 510 to 540 nm.

5. The illumination unit according to claim 4, **characterized in that** a light-emitting diode based on InGaN or InGaAlP is used as the primary radiation source.

6. The illumination unit according to claim 4, **characterized in that** a part of the primary radiation is furthermore converted by means of further luminescent substances into longer-wave radiation, wherein at least one luminescent substance has an FWHM of at most 90 nm.

7. The illumination unit according to claim 6, **characterized in that** a second luminescent substance is connected upstream from the light source, which emits in red and originates from the class AEAlSiN₃:Eu, where AE = Ca and/or Sr, alone or in combination.

8. The illumination unit according to one of the proceeding claims, wherein the light source is used together with three color filters, wherein light source and color filters are adapted to one another such that a predefined color space is covered by at least 85%, wherein the color space is in particular NTSC.

9. The illumination unit according to one of the proceeding claims, wherein the light source is used together with at least one color filter for the red spectral range having a maximum in the range of 625 to 655 nm, together with a color filter for the green spectral range having a maximum in the range of 515 and 535 and together with a color filter for the blue spectral range having a maximum in the range of 435 to 455 nm.

## Revendications

1. Unité d'éclairage pour un rétroéclairage à LCD, comprenant
- au moins un filtre de couleur,
- une source lumineuse comprenant une source primaire de rayonnement qui émet un rayonnement dans la plage des ondes courtes du domaine spectral optique dans la gamme de longueur d'ondes de 420 à 480 nm, et
- au moins un premier luminophore qui convertit ce rayonnement entièrement ou en partie en rayonnement secondaire d'ondes plus longues dans le domaine spectral visible, le premier luminophore provenant de la classe des orthosilicates (NOS) nitridiquement modifiés, qui est dérivé de la structure M₂SiO₄ :D, et cet orthosilicate étant un orthosilicate stabilisé avec RE et N, de sorte que la stoechiométrie d'approche correspond à la formule EA₂₋ₓ₋ₐREₓEuₐSi_{1-y}O_{4-x-2y}Nₓ,
- le luminophore présentant en tant que composant M principalement le groupe EA = Sr, Ba, Ca ou Mg, seul ou en combinaison
- le dopage d'activation D étant au moins constitué de Eu et substituant une fraction de M,
- une proportion de SiO₂ étant amenée en quantité inférieure et le facteur y qui détermine le déficit étant situé dans la plage de 0 < y ≤ 0,1,
- la proportion a de Eu étant entre a = 0,01 et 0,20,
- la proportion x étant entre 0,002 et 0,02, - RE = La ou Lu ou Dy ou Yb, seuls ou en combinaison, et
- la demi-largeur FWHM du premier luminophore étant au maximum de 90 nm.

2. Unité d'éclairage selon la revendication 1, **caractérisée en ce que** pris ensemble, EA contient au moins 66 % en moles en Sr et Ba, avec une proportion de Ca de maximum 5 % en moles et avec une proportion de Mg de maximum 30% en moles, EA étant un mélange de Sr et de Ba, avec Sr/Ba = 0,3 à 2,3, de préférence un mélange de Sr et de Ba avec Sr/Ba = 0,8 à 1,2, et de manière particulièrement préférée un mélange constitué de Sr et de Ba, avec Sr/Ba = 0,9 à 1,1.

3. Unité d'éclairage selon la revendication 1, **caractérisée en ce que** le facteur y qui détermine le déficit est situé dans la plage de 0,002 ≤ y ≤ 0,02.

4. Unité d'éclairage selon la revendication 1, **caractérisée en ce que** la source primaire de rayonnement émet dans le bleu dans la plage de longueur d'ondes de 440 à 470 nm, ce rayonnement étant converti en partie en rayonnement secondaire vert dans le domaine spectral visible au moyen du premier luminophore, avec une émission de crête située dans la plage de 510 à 540 nm.

5. Unité d'éclairage selon la revendication 4, **caractérisée en ce qu'**une diode électroluminescente sur la base de InGaN ou InGaAlP est utilisée comme source primaire de rayonnement.

6. Unité d'éclairage selon la revendication 4, **caractérisée en ce qu'**une partie du rayonnement primaire est en outre convertie en rayonnement d'ondes plus longues au moyen des luminophores supplémentaires, au moins un luminophore présentant une FWHM de maximum 90 nm.

7. Unité d'éclairage selon la revendication 6, **caractérisée en ce qu'**un deuxième luminophore se trouve en amont de la source lumineuse, lequel émet du rouge et provient de la classe AEAlSiN₃ : EU, avec AE = Ca et/ou Sr, seuls ou en combinaison.

8. Unité d'éclairage selon l'une quelconque des revendications précédentes, **caractérisée en ce que** la source lumineuse est utilisée en association avec trois filtres de couleur, la source lumineuse et les filtres de couleurs étant adaptés les uns aux autres de manière à ce qu'un espace de couleur prédéfini soit couvert à au moins 85%, l'espace de couleur étant NTSC.

9. Unité d'éclairage selon l'une quelconque des revendications précédentes, **caractérisée en ce que** la source lumineuse est utilisée en association avec au moins un filtre de couleur pour le domaine spectral rouge avec un maximum situé dans la plage de 625 à 655 nm, en association avec un filtre de couleur pour le domaine spectral vert avec un maximum situé dans la plage de 515 à 535 nm et en association avec un filtre pour le domaine spectral bleu avec un maximum situé entre 435 à 455 nm.
